# EUROPEAN PATENT SPECIFICATION

(11) **EP 0 655 815 B1**
(45) Date of publication and mention of the grant of the patent: **04.06.1997**
(21) Application number: 93830484.7
(22) Date of filing: 30.11.1993
(51) Int. Cl.: H02G 3/00, H01L 21/00, B23K 20/10

(54) **an instrument for the electrical connection of integrated circuits**
Einrichtung für die elektrische Verbindung von integrierten Schaltungen
Dispositif pour la connexion électrique de circuits intégrés

(43) Date of publication of application: 31.05.1995
(73) Proprietor: SGS-THOMSON MICROELECTRONICS S.r.l., 20041 Agrate Brianza (Milano) (IT)
(72) Inventor: Romano', Luigi, I-20052 Monza (Milan) (IT); Magni, Pierangelo, I-20058 Villasanta (Milan) (IT)
(74) Representative: Maggioni, Claudio

(56) References cited:
- EP-A- 0 262 777
- JAPANESE JOURNAL OF APPLIED PHYSICS, SUPPLEMENTS, vol.28, no.1, March 1989, TOKYO JA pages 137 - 139, XP85276 J.TSUJINO 'Welding Characteristics of Ultrasonic Wire Bonding Using the Same or a Different Frequency Complex Vibration Welding Tips'

## Description

### Field of application

The present invention relates to an instrument for the electrical connection of predetermined areas of a plate of semiconductor material, commonly known as a "chip", to metal terminals by fine wires.

In the manufacture of semiconductor electronic devices, in particular integrated circuits, operations to connect the chip to the metal terminals used for external connections are generally carried out by microbonding fine gold wires, using either heat-compression or ultrasound. Such operations are normally carried out by instruments known as wire bonders, which have a bonding head which includes a ceramic capillary tube through which runs a gold wire, means for supporting and feeding this wire and an ultrasound generator or, alternatively, microresistances which act on the gold wire.

The type of instrument most commonly used and to which, in any case, this invention relates, is that using ultrasound.

It is known that a fundamental requirement in the manufacture of integrated circuits is that such products be highly and consistently reliable. This reliability depends largely on the quality of the bonding that connects the chip and the external terminals of the semiconductor device. In order to improve these bonds, it is necessary to have access to ever more advanced instruments.

### Prior art

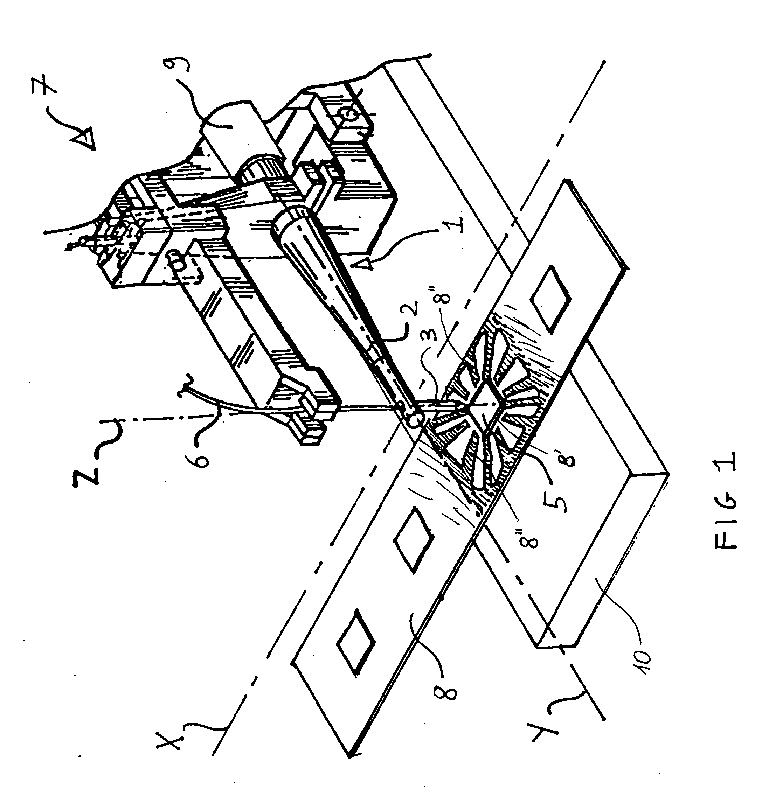

A few details of one commonly used instrument are illustrated in Figure 1. In particular, a chip 5 is fixed, along with other similar chips to a metal strip 8 worked in such a way as to have identical structures each having one portion 8' which acts as support for the chip and others 8" which will be the terminals of the device. This strip rests on a heated base 10 and is advanced by means which are not shown in such a way that each chip may be bonded in turn.

The bonding head of the instrument, generally indicated 7, has an ultrasound transducer 1 which includes an ultrasound generator 9 and a metal portion 2 for transmitting the ultrasonic vibrations to a ceramic capillary tube 3 which is securely fixed to one end of the portion 2 and extends perpendicular thereto. A device, in itself known and therefore not shown, feeds and supports a fine gold wire 6. The gold wire 6 runs through the capillary tube 3. The ultrasound transducer 1 transmits to the ceramic capillary tube 3 containing the gold wire a reciprocating movement at an ultrasonic frequency in a fixed direction which coincides with the axis Y of the transducer itself. This vibration, together with the pressure exerted by the ceramic tube and the fairly high temperature (180-260 degrees centigrade) to which the chip is heated, enables the wire to be bonded.

An instrument of this type can carry out two types of bonding on semiconductor electronic devices: a first type of bonding (known as ball-bonding) occurs when the gold wire is bonded onto an area or pad of the chip and a second type (wedge-bonding) occurs when the gold wire is bonded to the metal terminal of the device.

The two types of bonding (ball-bonding and wedge-bonding) are carried out as follows:
- a small portion of the gold wire is fed from the ceramic capillary tube 3 and fused by a hydrogen flame or by an electric discharge, using known means which are not shown, so as to form a ball at the end of the wire;
- the ceramic tube is positioned on the pad by the actuator and control device of the bonding head and the ball is compressed between the pad and the tube;
- the ultrasound transducer is activated and it effects the bonding by causing the ceramic tube to vibrate;
- the bonding head is raised, leaving the wire free to run within the tube;
- the ceramic tube is then positioned on the metal terminal to which the other end of the length of wire is to be bonded;
- the ceramic tube is pressed onto the terminal and the ultrasound transducer is activated simultaneously, thereby deforming the wire and bonding it to the terminal; the bond has the shape of a wedge;
- the ceramic tube is raised so as to break the wire at its thinnest point;
- the length of wire protruding from the tube may then be fused for the next bonding.

The two types of bonding have very different mechanical characteristics and their reliability therefore also differs. The first type of bonding is symmetrical in terms of both shape and of the position of the wire to be bonded (always vertical within the ceramic tube), while the second type is markedly asymmetric as the wire may be at any angle whatever to the axis Y of the ultrasound transducer and therefore to the direction of the ultrasonic vibrations which effect the bonding. If the portion of wire to be bonded is not parallel to the direction of the ultrasonic vibrations, the bonds may not be perfect; in practice, it may be said that bonding efficiency depends on the above angle and is at its maximum at angles of 0 and 180 degrees and at its minimum at angles of 90 and 270 degrees.

The prior art offers two solutions to this problem: a first which provides for an increases in the power of the signal applied to the transducer by a magnitude which is proportional to the angle between the wire to be bonded and the axis of the ultrasound transducer and a second which provides for the bonding head itself to vibrate along a direction perpendicular to the direction of the ultrasonic vibration. However, in this latter case the vibration of the bonding head has a lower frequency and greater amplitude than that of the ultrasound transducer, owing to the considerable mass of the head. In addition, the inertia of the head leads to a considerable delay between the activation command and the actual vibration of the head.

A certain increase in bonding efficiency is obtained by applying these arrangements to prior art instruments but this is not always enough to satisfy the semi-conductor market's demands for ever increasing reliability. This bonding efficiency is not satisfactory specially when the angle of the wire to the axis of the transducer approaches 90 or 270 degrees.

A further solution, as known from Japanese Journal of Applied Physics, Supplements, Vol. 28, n°1, March 1989 Tokyo, Japan, pages 137-139, XP85276, Authors: J-Tsujino et al., provides two longitudinal vibration systems placed at right angles in contact with the bonding head.

### Summary of the invention

The problem at the root of the present invention is that of providing an instrument of the type described above which has structural and operating characteristics able to overcome the disadvantages reported with reference to the prior art.

This problem is solved according to the invention by an instrument as defined in the preamble of either claim 1 or claim 2, characterised in that the resonator is either acoustic or magnetic, respectively.

The function of the resonator is to make the end of the ultrasound transducer, to which the ceramic capillary tube is fixed, resonate, thereby causing vibrations perpendicular to the vibrations produced by the transducer itself.

The characteristics and advantages of an instrument according to the invention will become apparent from the following description of a preferred embodiment, given purely by way of non-limitative example with reference to the appended drawings.

### Brief description of the drawings

In these drawings:
Figure 1 is a partial perspective view of a prior art instrument, the operation of which has been described,
Figure 2 is a partial perspective view of an instrument according to the invention in which the resonator is securely fixed to the base of the instrument,
Figure 3 is a plan view of a detail of the bonding head according to the invention during a bonding operation,
Figure 4 is a cross-section of a preferred embodiment of the ultrasound transducer, and
Figure 5 is a partial perspective view of an instrument according to the invention in which the resonator is securely fixed to the bonding head.

### Detailed description

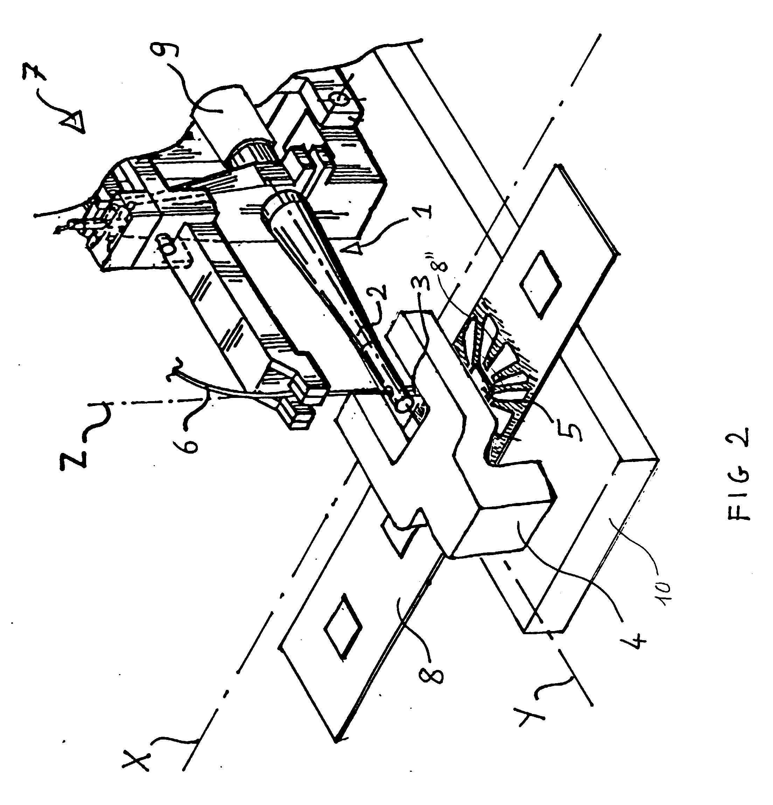

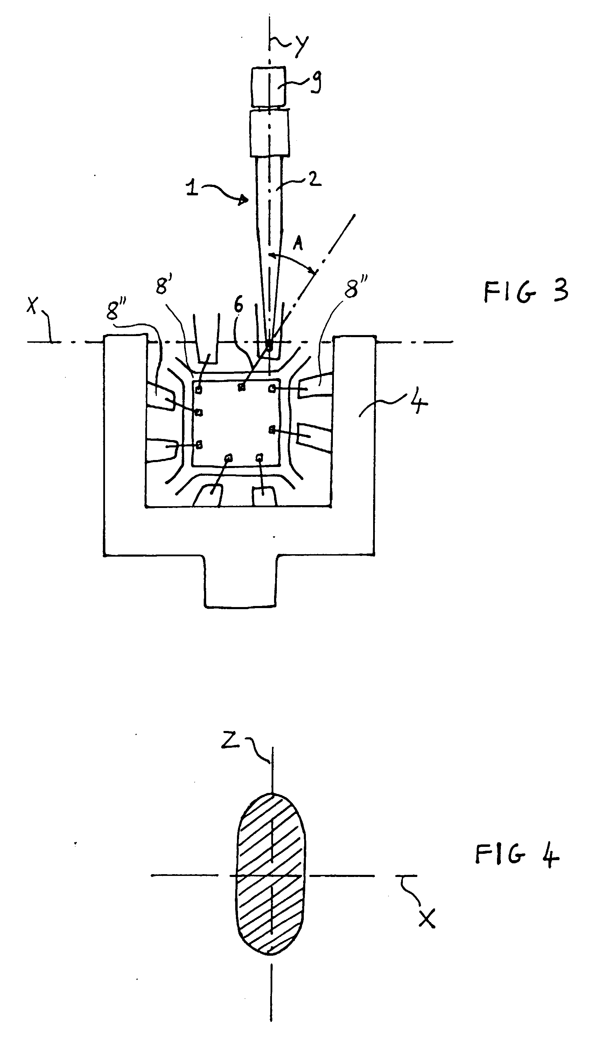

With reference to Figures 2 and 3, in which parts which are the same as or equivalent to parts of Figure 1 are indicated by the same reference numbers, a bonding head is generally indicated 7 and has an ultrasound transducer 1 to one end of which a capillary tube 3 is securely fixed and forms a guide for the fine gold wire 6, and a metal strip is indicated 8 onto which chips are fixed on which the instrument is to carry out the bonding. The direction of the oscillating movement imposed on the capillary tube by the transducer is indicated Y, this direction coinciding with the axis of the transducer itself. The direction parallel to the work surface and perpendicular to the direction Y is indicated X.

A resonator 4, of either acoustic or magnetic type, is securely fixed to the base of the instrument. This is associated with the end portion of the bonding head, that is with the transducer 1, and is arranged, shaped and powered so as to cause the end of the ultrasound transducer 1, to which the ceramic capillary tube 3 is fixed, to resonate and therefore to vibrate along the direction X perpendicular to the axis of the transducer itself.

The first type of bonding (ball-bonding), of the gold wire onto a pad of the chip, is effected in exactly the same way as it is by the prior art instrument shown in Figure 1 and described earlier.

The second type of bonding, known as wedge-bonding because of the shape of the bond, is carried out as follows:
- the ceramic tube is positioned on the metal terminal 8" to which the other end of the portion of wire is to be bonded;
- the ceramic tube is pressed onto the terminal at the same time as the ultrasound transducer and the resonator are activated, thus bonding the wire to the terminal. The ultrasound transducer causes the ceramic tube to vibrate in a first mode along the axis of the transducer itself (the direction indicated Y in the drawings), while the resonator simultaneously causes it to vibrate in a second mode, with a comparable frequency and amplitude to those of the first mode, along a direction (indicated X) perpendicular to that of the first mode and substantially parallel to the work surface on which the chip to be bonded is arranged.

The action of the resonator is varied according to the angle (indicated A in Figure 3) between the piece of wire to be bonded and the axis of the ultrasound transducer so as proportionally to compensate for the decrease in bonding efficiency.

Modulator means, not shown in the drawings, enable the strength of the vibrations induced by the resonator 4 to be modulated according to the angle A.

This angle is measured by the system which controls the movement of the bonding head on the basis of movements carried out along the two axes X and Y between two successive bondings.

The ability to vary the effect of the resonator provides a substantially constant bonding efficiency which does not depend on the angle of the wire to be bonded.

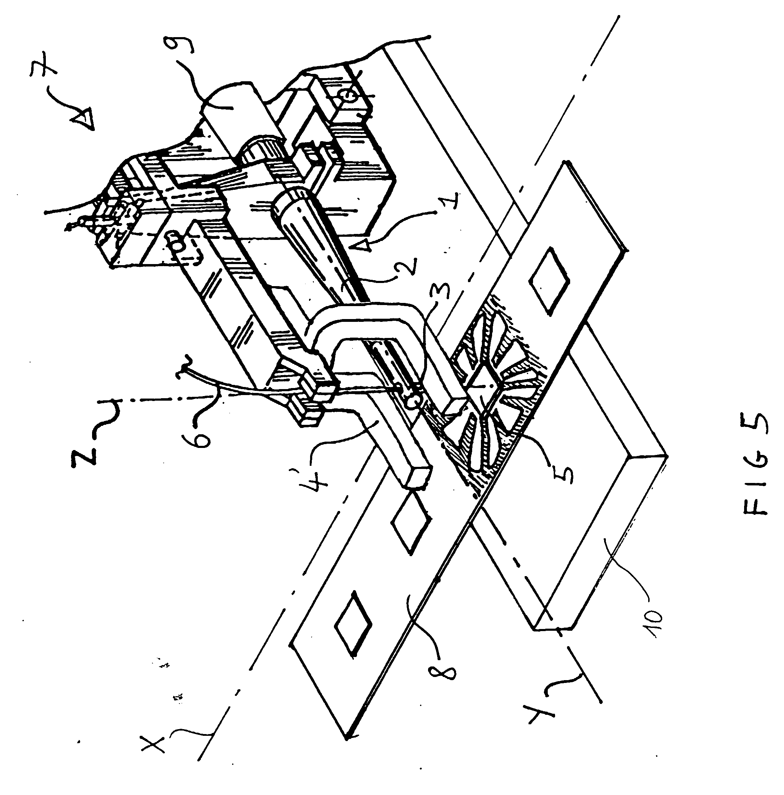

In order to ensure that the vibrations induced in the end of the transducer by the resonator are contained in a plane parallel to the work surface, it is useful for the section of the transducer to be elongate along the vertical axis Z so as to facilitate bending in the horizontal plane and to limit bending in the vertical plane. An example of such a cross-section is shown in Figure 4.

The resonator, used here to make the end of the ultrasound transducer vibrate, is in itself known and may be either of a magnetic or an acoustic type. As to its position, the resonator may be securely fixed equally successfully either to the base 10, as shown in Figures 2 and 3, or to the bonding head, as shown in Figure 5 where it is indicated 4'.

The instrument described above has the advantage over the prior art of enabling bonding to be effected with a high degree of reliability, independently of the alignment of the gold wire on the surface where the bonding is being carried out, thanks to a second vibration, along a direction perpendicular to the first, of a frequency comparable to that of the first and of a sufficiently limited amplitude.

It is clear that numerous alterations, adjustments, additions and variations may be made to the embodiment described above purely by way of non-limitative example and that elements may be replaced by others of equivalent function without departing thereby from the protective scope of the Claims which follow.

## Claims

1. An instrument for the electrical connection of predetermined areas of a plate of semiconductor material to metal connector terminals by portions of wire, including:
- a device for feeding the wire (6)
- a bonding head (7) having an end portion (2, 3) which includes means (3) for guiding and applying the wire,
- an ultrasound generator (9) connected to the end portion (2, 3) of the bonding head so as to make it vibrate along a predetermined direction (Y), and
- a resonator (4) associated with the end portion (2, 3) of the bonding head so as to make it vibrate along a direction (X) which is substantially perpendicular to the direction (Y) of the vibration induced by the generator,
whereby the resonator is of acoustic type.

2. An instrument for the electrical connection of predetermined areas of a plate of semiconductor material to metal connector terminals by portions of wire, including:
- a device for feeding the wire (6),
- a bonding head (7) having an end portion (2, 3) which includes means (3) for guiding and applying the wire,
- an ultrasound generator (9) connected to the end portion (2, 3) of the bonding head so as to make it vibrate along a predetermined direction (Y), and - a resonator (4) associated with the end portion (2, 3) of the bonding head so as to make it vibrate along a direction (X) which is substantially perpendicular to the direction (Y) of the vibration induced by the generator,
whereby the resonator is of magnetic type.

3. An instrument according either to Claim 1 or to Claim 2, characterised in that it includes a base which supports the bonding head (7) and in that the resonator (4) is securely fixed to the base.

4. An instrument according either to Claim 1 or to Claim 2, characterised in that the resonator is securely fixed to the bonding head.

5. An instrument according either to Claim 3 or to Claim 4, characterised in that it includes modulator means for modulating the strength of the vibrations induced by the resonator (4) according to the angle between the portion of wire being bonded at any one time by one of its ends to one of the predetermined areas of the plate, and the direction along which the end portion (2, 3) of the bonding head (7) is vibrating.

## Patentansprüche

1. Eine Einrichtung für die elektrische Verbindung vorbestimmter Bereiche einer Platte aus einem Halbleitermaterial mit Metall-Verbinderanschlüssen durch Drahtabschnitte mit folgenden Merkmalen:
- einer Vorrichtung zum Zuführen des Drahts (6),
- einem Bondkopf (7) mit einem Endabschnitt (2, 3), der eine Einrichtung (3) zum Führen und Aufbringen des Drahts aufweist,
- einem Ultraschallgenerator (9), der mit dem Endabschnitt (2, 3) des Bondkopfs verbunden ist, um zu bewirken, daß derselbe entlang einer vorbestimmten Richtung (Y) schwingt, und
- einem Resonator (4), der dem Endabschnitt (2, 3) des Bondkopfs zugeordnet ist, um zu bewirken, daß derselbe entlang einer Richtung (X) schwingt, die im wesentlichen senkrecht zu der Richtung (Y) der Schwingung, die durch den Generator induziert ist, ist, wodurch der Resonator von einem akustischen Typ ist.

2. Eine Einrichtung für die elektrische Verbindung vorbestimmter Bereiche einer Platte aus einem Halbleitermaterial mit Metall-Verbinderanschlüssen durch Drahtabschnitte mit folgenden Merkmalen:
- einer Vorrichtung zum Zuführen des Drahts (6),
- einem Bondkopf (7) mit einem Endabschnitt (2, 3), der eine Einrichtung (3) zum Führen und Aufbringen des Drahts aufweist,
- einem Ultraschallgenerator (9), der mit dem Endabschnitt (2, 3) des Bondkopfs verbunden ist, um zu bewirken, daß derselbe entlang einer vorbestimmten Richtung (Y) schwingt, und
- einem Resonator (4), der dem Endabschnitt (2, 3) des Bondkopfs zugeordnet ist, um zu bewirken, daß derselbe entlang einer Richtung (X) schwingt, die im wesentlichen senkrecht zu der Richtung (Y) der Schwingung, die durch den Generator induziert wird, ist, wodurch der Resonator von einem magnetischen Typ ist.

3. Eine Einrichtung gemäß Anspruch 1 oder 2, dadurch gekennzeichnet, daß dieselbe eine Basis aufweist, die den Bondkopf (7) trägt, und daß der Resonator (4) fest an der Basis befestigt ist.

4. Eine Einrichtung gemäß Anspruch 1 oder 2, dadurch gekennzeichnet, daß der Resonator fest an dem Bondkopf befestigt ist.

5. Eine Einrichtung gemäß Anspruch 3 oder 4, dadurch gekennzeichnet, daß dieselbe eine Modulatoreinrichtung zum Modulieren der Stärke der Schwingungen, die durch den Resonator (4) induziert werden, entsprechend dem Winkel zwischen dem Drahtabschnitt, der zu irgendeinem Zeitpunkt durch eines seiner Enden an einen der vorbestimmten Bereiche der Platte gebondet wird, und der Richtung, entlang der der Endabschnitt (2, 3) des Bondkopfs (7) schwingt, aufweist.

## Revendications

1. Instrument pour la connexion électrique de zones prédéterminées d'une plaque de matière semiconductrice à des bornes métalliques d'un connecteur par des parties de fil, comprenant :
- un dispositif destiné à faire avancer le fil (6),
- une tête (7) de connexion ayant une partie extrême (2, 3) qui comprend un moyen (3) destiné à guider et appliquer le fil,
- un générateur (9) d'ultrasons relié à la partie extrême (2, 3) de la tête de connexion pour la faire vibrer dans une direction prédéterminée (Y), et
- un résonateur (4) associé à la partie extrême (2, 3) de la tête de connexion pour la faire vibrer dans une direction (X) qui est sensiblement perpendiculaire à la direction (Y) de la vibration induite par le générateur,
le résonateur étant du type acoustique.

2. Instrument pour la connexion électrique de zones prédéterminées d'une plaque de matière semiconductrice à des bornes métalliques de connexion par des parties de fil, comprenant :
- un dispositif pour faire avancer le fil (6),
- une tête (7) de connexion ayant une partie extrême (2, 3) qui comprend un moyen (3) pour guider et appliquer le fil,
- un générateur (9) d'ultrasons relié à la partie extrême (2, 3) de la tête de connexion afin de la faire vibrer dans une direction prédéterminée (Y), et
- un résonateur (4) associé à la partie extrême (2, 3) de la tête de connexion afin de la faire vibrer dans une direction (X) qui est sensiblement perpendiculaire à la direction (Y) de la vibration induite par le générateur,
le résonateur étant du type magnétique.

3. Instrument selon la revendication 1 ou la revendication 2, caractérisé en ce qu'il comprend une embase qui supporte la tête (7) de connexion et en ce que le résonateur (4) est assujetti fixement à l'embase.

4. Instrument selon la revendication 1 ou la revendication 2, caractérisé en ce que le résonateur est assujetti fixement à la tête de connexion.

5. Instrument selon la revendication 3 ou la revendication 4, caractérisé en ce qu'il comprend un moyen modulateur destiné à moduler la force des vibrations induites par le résonateur (4) en fonction de l'angle formé entre la partie du fil en cours de connexion, à un instant quelconque, par l'une de ses extrémités à l'une des zones prédéterminées de la plaque, et la direction dans laquelle la partie extrême (2, 3) de la tête (7) de connexion vibre.
